# EUROPEAN PATENT APPLICATION

(11) **EP 4 488 777 A1**
(43) Date of publication of application: **08.01.2025**
(21) Application number: 22929617.3
(22) Date of filing: 29.11.2022
(51) Int. Cl.: G05B 19/418

(54) **WAFER TRANSFER SUPERVISION CONTROL METHOD AND SYSTEM, COMPUTER DEVICE AND STORAGE MEDIUM**

(30) Priority: 04.03.2022 CN 202210208127
(71) Applicant: Meetfuture Technology (Shanghai) Co., Ltd., Shanghai 200131 (CN)
(72) Inventor: SHEN, Guoli, Shanghai 200131 (CN); MIAO, Feng, Shanghai 200131 (CN)
(74) Representative: Balder IP Law, S.L.
(86) International application number: PCT/CN2022/135181
(87) International publication number: WO 2023/165189

(57) **Abstract**

Disclosed are a wafer transfer supervision control method and system, a computer device, and a storage medium, relating to the field of wafer transfer control. The method includes: generating, by a manufacturing execution unit, a transfer instruction, where the transfer instruction includes a plurality of commands, and the plurality of commands are jointly indicative of a first transfer path based on an instruction sequence of the first transfer path (201); receiving, by a material control unit, the transfer instruction sent according to the instruction sequence of the first transfer path (202); obtaining, by the material control unit, transfer state information of the target wafer indicated in the transfer instruction (203); adjusting, by the material control unit, the first transfer path indicated in the transfer information according to the transfer state information, generating a target transfer path of the target wafer, and sending the target transfer path to a material handling unit according to an instruction sequence of the target transfer path (204); and controlling the material handling unit to transport the target wafer according to the target transfer path sent by the material control unit (205). A plurality of commands can be transmitted at a time, and interaction time and frequency of transmission between different units are reduced, thus increasing a program processing speed.

## Description

### CROSS REFERENCE TO RELATED APPLICATIONS

The present application claims priority to Chinese Patent Application No. CN202210208127.7, filed on March 4, 2022, the entire disclosure of which is incorporated herein by reference in its entirety.

### TECHNICAL FIELD

The present disclosure relates to the technical field of semiconductor wafer transfer control, and more specifically to a wafer transfer supervision control method and system, a computer device, and a storage medium.

### BACKGROUND

When a front opening unified pod (FOUP) is to be transferred, a manufacturing execution system (MES) indicates a destination stocker, and then the MES sends a transfer instruction to a material control system (MCS) of an automated material handling system. After receiving the transfer instruction, the MCS notifies a transfer manager to execute transferring of the FOUP. During the transferring, the MES can merely send transfer instructions to the MCS one by one, and the MCS needs to interact with the MES several times, which may be time-consuming and not cost-effective.

In view of the above, the present application provides a technical solution for solving the above technical problem.

### SUMMARY

Embodiments of the present disclosure provide a wafer transfer supervision control method, including: generating, by a manufacturing execution unit, a transfer instruction, where the transfer instruction carries transfer information of a target wafer, the transfer instruction includes a plurality of commands, and the plurality of commands are jointly indicative of a first transfer path based on an instruction sequence of the first transfer path; receiving, by a material control unit, the transfer instruction sent by a production unit according to the instruction sequence of the first transfer path; obtaining, by the material control unit, transfer state information of the target wafer indicated in the transfer instruction; adjusting, by the material control unit, the first transfer path indicated in the transfer information according to the transfer state information, generating a target transfer path of the target wafer, and sending the target transfer path to a material handling unit according to an instruction sequence of the target transfer path; and controlling the material handling unit to transport the target wafer according to the target transfer path sent by the material control unit.

A wafer transfer supervision control system is provided according to the present disclosure, which includes: a manufacturing execution unit configured to generate a transfer instruction, where the transfer instruction carries transfer information of a target wafer, the transfer instruction includes a plurality of commands, and the plurality of commands are jointly indicative of a first transfer path based on an instruction sequence of the first transfer path; a material control unit configured to receive the transfer instruction sent by a production unit according to the instruction sequence of the first transfer path, to obtain transfer state information of the target wafer indicated in the transfer instruction, to adjust the first transfer path indicated in the transfer information according to the transfer state information, to generate a target transfer path of the target wafer, and to send the target transfer path to a material handling unit according to an instruction sequence of the target transfer path; and the material handling unit being configured to transport the target wafer according to the target transfer path sent by the material control unit.

A computer device is provided and includes at least one memory and at least one processor. The at least one memory is configured to store computer programs, and the at least one processor is configured to execute the computer programs to implement the steps of the method as described above.

A computer-readable storage medium is provided and store computer programs thereon. The computer programs are executed by at least one processor to implement the steps of the method as described above.

### BRIEF DESCRIPTION OF THE DRAWINGS

Preferred embodiments of the present disclosure will be described below with reference to the accompanying drawings in an explicit and intelligible manner, to further describe the above characteristics, technical features, advantages, and implementations.
FIG. 1 is a schematic structural diagram of a wafer transfer supervision control system according to embodiments of the present disclosure.
FIG. 2 is a schematic flow chart of a wafer transfer supervision control method according to embodiments of the present disclosure.
FIG. 3 is a flow chart of an operation process of a material control unit according to embodiments of the present disclosure.
FIG. 4 is a schematic flow chart of steps for generating a target transfer path according to embodiments of the present disclosure.

### DETAILED DESCRIPTION OF THE EMBODIMENTS

To enable objectives, technical solutions, and advantages of the present disclosure clearer, some embodiments of the present disclosure are described in detail below with reference to the accompanying drawings and the embodiments.

The embodiments of the present disclosure are explained below through specific examples, so that a person skilled in the art may easily understand other advantages and effects of the present disclosure from contents of the disclosure. It is apparent that the described embodiments are only some embodiments of the present disclosure, rather than all embodiments. The present disclosure may also be implemented or applied through different embodiments, and the details in the disclosure may be modified or changed, based on different views and applications, without deviating from the spirit of the present disclosure. It is to be noted that the following embodiments and features therein may be combined with each other without confliction. Based on the embodiments in the present disclosure, all other embodiments obtained by those of ordinary skill in the art without creative efforts fall within the scope of protection of the present disclosure.

It is to be noted that the following describes various aspects of the embodiments within the scope of the appended claims. It is apparent that the aspects described herein can be embodied in various forms and that any particular structure and/or function described herein are merely illustrative. Based on the present disclosure, those skilled in the art shall understand that one aspect described herein can be implemented independently of any other aspect and that two or more of these aspects can be combined in various ways. For example, the device and/or method in this paper can be implemented or practiced by using any number and aspects described herein. In addition, the device and/or method may be implemented or practiced by using structures and/or functions other than those described in the aspects of this paper.

It is also to be noted that the diagrams provided in the following embodiments only schematically illustrates the basic concept of the present disclosure. Those diagrams merely show the components related to the present disclosure rather than show the actual number, shape and size of the components in the actual implementation. The shape, number and scale of the components may be changed at will in the actual implementation, and the layout of the components may also be more complicated.

In addition, specific details are described below for thorough understanding of the embodiments. However, it will be understood by those skilled in the art that those aspects described herein may be practiced without these specific details.

Semiconductor elements are generally manufactured through a series of processes, and the processes are performed in a specific sequence and generally in a specific time period by using a variety of devices. The main function of a material flow system in a wafer fabrication facility (FAB) is to transfer one or more wafers to a corresponding device at a correct time point and track a location and status of the wafers in the entire manufacturing process.

The automated material handling system (AMHS) has been widely used in the material flow system in recent years due to being capable of more effectively, accurately, and safely achieving automation functions than manual devices.

When a front opening unified pod (FOUP) is to be transferred, a manufacturing execution system (MES) indicates a destination stocker, and then the MES sends a transfer instruction to a material control system (MCS) of an automated material handling system. After receiving the transfer instruction, the MCS notifies a transfer manager to execute transferring of the FOUP. During the transferring, the MES can merely send transfer instructions to the MCS one by one, and the MCS needs to interact with the MES several times, which may be time-consuming and not cost-effective.

Embodiments of the present disclosure provide a wafer transfer supervision control method. The method includes: generating, by a manufacturing execution unit, a transfer instruction, where the transfer instruction carries transfer information of a target wafer, the transfer instruction includes a plurality of commands, and the plurality of commands are jointly indicative of a first transfer path based on an instruction sequence; receiving, by a material control unit, the transfer instruction sent by a production unit according to the instruction sequence; obtaining, by the material control unit, transfer state information of the target wafer from the transfer instruction; adjusting, by the material control unit, the first transfer path in the transfer information according to the transfer state information, generating a target transfer path of the target wafer, and sending the target transfer path to a material handling unit according to the instruction sequence; and controlling the material handling unit to transport the target wafer according to the target transfer path sent by the material control unit.

Compared with the related technologies, implementing the present disclosure has following advantages. Multiple instructions can be transmitted at a time, reducing the time and number/frequency of interactions between different units and increasing a speed of program processing.

Some embodiments of the present disclosure will be further described in detail below in combination with the accompanying drawings and embodiments.

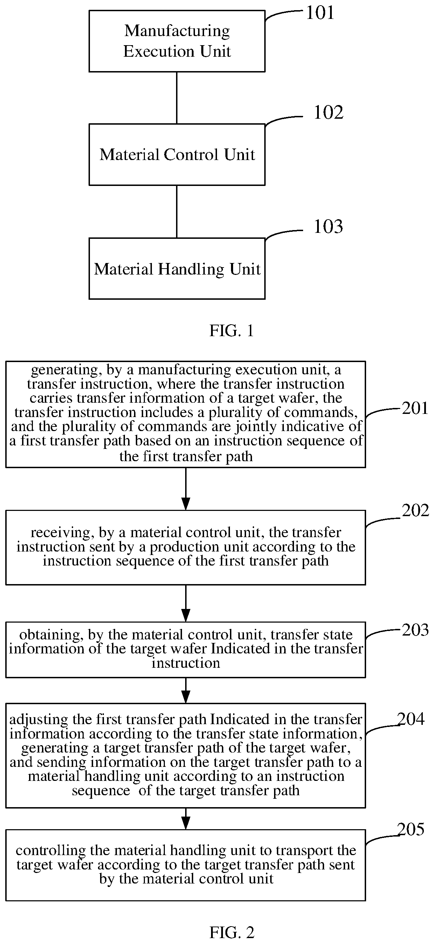

As shown in FIG. 1, an embodiment of the present disclosure provides a wafer transfer supervision control system. The system includes a manufacturing execution unit 101, a material control unit 102, and a material handling unit 103.

The manufacturing execution unit 101 is configured to generate a transfer instruction. The transfer instruction carries transfer information of one or more target wafers, the transfer instruction includes multiple commands, and the multiple commands are jointly indicative of a first transfer path based on an instruction sequence of the first transfer path. The manufacturing execution unit 101 is embodied as a production informatization management unit (e.g., MES) for a workshop executive level of a manufacturing enterprise. The MES can send the transfer instruction to the material control unit 102 (e.g., MCS) according to a list of stockers, i.e., a next transfer location of the wafer is notified to the MCS by the MES. After receiving the transfer request/instruction from the MES, the MCS uses racks in the stockers as a basis for load balancing.

The material control unit 102 is configured to receive the transfer instruction sent by the production informatization management unit according to the instruction sequence of the first transfer path, to obtain transfer state information of the target wafer indicated in the transfer instruction, to adjust the first transfer path indicated in the transfer information according to the transfer state information to generate a target transfer path of the target wafer, and to send the target transfer path to the material handling unit according to an instruction sequence of the target transfer path. The material control unit is embodied as the material control system (MCS), which is mainly used for transport and management of front opening unified pod (FOUP) in the FAB. The transport of the FOUP includes transport inside a clean room (FAB), transport between different clean rooms (FAB), and transport across floors. The transport covers machines, warehouses or stockers (e.g., STK), suspended temporary storage shelves (e.g., overhead buffers (OHB)), and conveyors. In this way, transport time between the machines can be reduced and the transport efficiency can be improved.

The material handling unit 103 is configured to transport the target wafer according to the target transfer path sent from the material control unit. The material handling unit 103 is embodied as an automatic material handling system (AMHS). The transport performed by the AMHS includes transport of interbay and transport of intrabay, where the overhead shuttle (OHS) is responsible for transport of the interbay, and the overhead hoist transport (OHT) is responsible for transport of the intrabay. The OHT may be an automated guided vehicle (AGV), a position guided vehicle (PGV), or a rail guided vehicle (RGV).

As shown in FIG. 2, embodiments of the present disclosure provide a wafer transfer supervision control method, and the method begins at step 201.

At step 201, a manufacturing execution unit generates a transfer instruction, where the transfer instruction carries transfer information of one or more target wafers, the transfer instruction includes multiple commands, and the multiple commands are jointly indicative of a first transfer path based on an instruction sequence of the first transfer path.

The manufacturing execution unit (e.g., MES) can generate the transfer instruction carrying the transfer information of the target wafer. The transfer information may at least include information of the first transfer path of the target wafer, or may at least include an initial storage location and a destination storage location of the target wafer. The transfer information may further include a storage space required by the target wafer. The transfer instruction may include the multiple commands, and the multiple commands are jointly indicative of the first transfer path. There is a time relationship between the multiple commands. The manufacturing execution unit can send the commands to the material control unit one by one according to the time relationship between the commands. The MES sends the transfer instruction to the MCS. Generally, the commands in the transfer instruction are sent one by one. In the disclosure, when two commands are sent at one time, the MCS also ensures that the two commands will be sent to an overhead vehicle controller (OHVC) over a transmission link according to the received instruction sequence (and the sequence is not disordered). Therefore, multiple commands can be transmitted at a time, thereby reducing the time and number of interactions between different units, and improving the program processing speed.

At step 202, a material control unit receives the transfer instruction sent by a production unit according to the instruction sequence.

The material control unit (e.g., MCS) receives the transfer instruction sent by the production unit according to the instruction sequence. The material control unit may not receive the multiple commands according to the time relationship between the commands. The material control unit may temporarily store the received multiple commands until it is determined that all the commands have been received. Thereafter, the material control unit may analyze the multiple commands to obtain the first transfer path from the multiple commands.

At step 203, the material control unit obtains transfer state information of the target wafer indicated in the transfer instruction.

The material control unit (e.g., MCS) obtains the transfer state information of the target wafer indicated in the transfer instruction. The transfer state information may indicate whether the target wafer exists, a current actual location of the target wafer, and whether a historical transfer instruction, for the target wafer, that has not been executed exists.

At step 204, the first transfer path indicated in the transfer information is adjusted according to the transfer state information to generate a target transfer path of the target wafer, and the target transfer path is sent to a material handling unit according to an instruction sequence of the target transfer path.

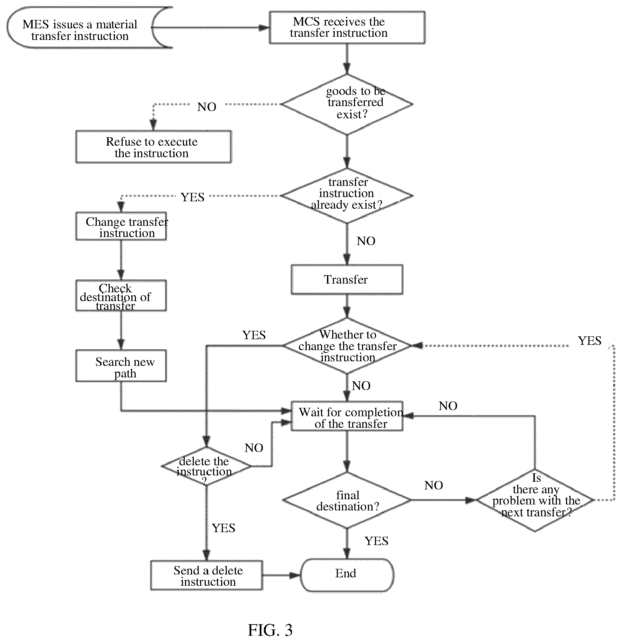

The material control unit MCS adjusts the first transfer path indicated in the transfer information according to the transfer state information, to generate the target transfer path of the target wafer. As shown in FIG. 3, the material control unit MCS determines, according to the transfer state information, whether the target wafer exists in a transfer system. If no target wafer exists in the transfer system, the material control unit MCS reports an error and skips executing the instruction. The material control unit MCS further determines, according to the transfer state information, whether a historical transfer instruction exists. If no historical transfer instruction exists, the material control unit MCS generates the target transfer path. If the historical transfer instruction exists, the material control unit MCS replaces the historical transfer instruction according to the newly received transfer instruction, and generates the target transfer path of the target wafer according to the newly received transfer instruction. The goods in FIG. 3 refers to the target wafer, and the destination refers to the destination storage location. The material control unit can send, according to the instruction sequence, the commands to the material handling unit one by one according to the time relationship between the commands.

At step 205, the material handling unit is controlled to transport the target wafer according to the target transfer path sent by the material control unit.

The material handling unit (AMHS) transports the target wafer according to the target transfer path sent by the material control unit.

In the above method, when two commands are sent at a time, the MCS can also ensure that the two commands will be sent to the OHVC over the transmission link according to the received instruction sequence (and the sequence is not disordered). Therefore, multiple commands can be transmitted at one time, reducing the interaction time and number of transmissions between different units, and improving the program processing speed.

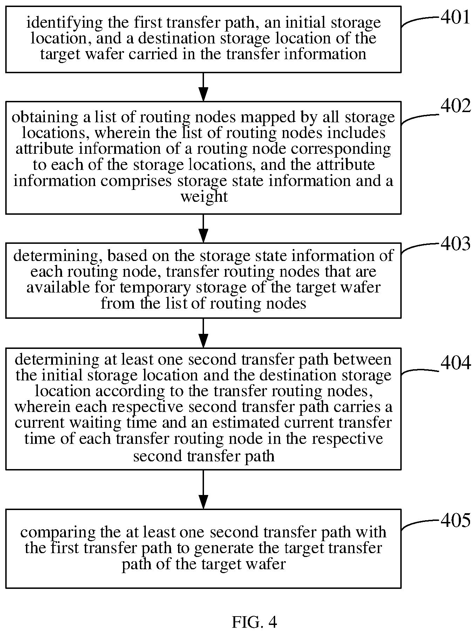

As shown in FIG. 4, in one embodiment, the material control unit adjusts the transfer information according to the transfer state information, to generate the target transfer path of the target wafer as follows.

At step 401, the first transfer path, an initial storage location, and a destination storage location of the target wafer carried in the transfer information are identified.

A server of the material control unit MCS can identify the first transfer path, the initial storage location, and the destination storage location of the target wafer carried in the transfer information.

At step 402, a list of routing nodes mapped by all storage locations is obtained, where the list of routing nodes includes attribute information of a routing node corresponding to each of the storage locations, and the attribute information includes storage state information and a weight.

The server of the material control unit MCS obtains the list of routing nodes mapped by all the storage locations, where the list of routing nodes includes the attribute information of the routing node corresponding to each of the storage locations, and the attribute information includes the storage state information and the weight. The storage locations include all physical addresses of the MCS that can be used for storing the FOUP, and thus also include physical addresses of the initial storage location and the destination storage location. One routing node may correspond to one storage location, but one storage location may correspond to multiple routing nodes. A storage location may have at least one storage entrance for FOUPs and at least one transfer exit for the FOUPs. The at least one storage entrance and the at least one transfer exit each correspond to a routing node. The attribute information may include a transfer device which can access the routing node, the storage state information, and the weight. The weight is obtained according to the number of times the transfer device is used in historical data of the material control unit. The storage state information may include information about one or more wafers that have already been stored in the routing node, and information about one or more wafers to be stored in the routing node in a specific time period.

At step 403, transfer routing nodes that are available for temporary storage of the target wafer are determined, based on the storage state information of each routing node, from the list of routing nodes.

The server in the MCS determines from the list of routing nodes, based on the storage state information of each routing node, the transfer routing nodes that are available for temporary storage of the one or more wafers to be transferred. The server can determine, according to the storage state information of each routing node, all idle transfer routing nodes.

At step 404, multiple second transfer paths between the initial storage location and the destination storage location are determined according to the transfer routing nodes, where each respective second transfer path carries a current waiting time and an estimated current transfer time of each of at least two transfer routing nodes in the respective second transfer path.

The server in the MCS determines, according to the determined transfer routing nodes, the initial storage location, and the destination storage location, connection lines between the transfer routing nodes. The server in the MCS determines, according to the connection lines between the transfer routing nodes, the multiple second transfer paths between the initial storage location and the destination storage location. It shall be understood that a connection line between nodes indicates that a transfer device that can transfer the wafer is available between the nodes. The server in the MCS calculates a total consumption time of each second transfer path according to the current waiting time and the estimated current transfer time of each transfer routing node, and selects one second transfer path having a minimum total consumption time from the multiple second transfer paths.

At step 405, the selected one second transfer path is compared with the first transfer path to generate the target transfer path of the target wafer.

The server in the MCS calculates a total consumption time of the first transfer path according to a current waiting time and an estimated current transfer time of each routing node in the first transfer path, and determines one of the selected one second transfer path and the first transfer path that has a less total consumption time as the target transfer path.

In the above manner, the available shortest path from the initial storage location to the destination storage location can be selected, so that the transfer can take the less time. Further, the transfer uniformity of the transfer devices reaching devices for receiving the wafers to be transferred can be ensured, which may avoid that some transfer devices are too busy or too idle, and achieve the full utilization of transfer resources.

In one embodiment, the transfer routing nodes that are available for the temporary storage of the target wafer are determined based on the storage state information of each routing node from the list of routing nodes as follows. A list of queuing wafers and a preset storage threshold of each of at least one routing node that is in a positive state and in the list of routing nodes are obtained. The transfer routing nodes that are available for the temporary storage of the target wafer are determined according to the preset storage threshold and queuing wafers in the list of queuing wafers of each of the at least one routing node, and the target wafer. A state of each of at least one routing node that is not available for storage of the target wafer in a preset number of transfer cycles is set to a negative state.

The server obtains the list of queuing wafers and the preset storage threshold of each of the at least one routing node that is in the positive state and in the list of routing nodes. The preset storage threshold may include a minimum storage capacity and a maximum storage capacity of a stocker where the storage location corresponding to the routing node is located. The server can calculate an used storage capacity according to the list of queuing wafers of each routing node. The server determines, according to the preset storage threshold, the wafer to be transferred, and the queuing wafers in the list of queuing wafers, the transfer routing nodes that are available for the temporary storage of the wafer to be transferred, and sets the state of each of the at least one routing node that is not available for storage of the wafer to be transferred in the preset number of transfer cycles to the negative state. Each transfer task is recorded as one transfer cycle, so the state information of the routing node varies with time. When a routing node is in a state that the routing node has already received the wafer or is about to receive the wafer, the state information of the routing node is set to the negative state. When a routing node is in an idle state, the state information is set to the positive state.

In one embodiment, the material control unit receives the transfer instruction sent by the production unit as follows. The material control unit receives the transfer instruction, sets state information of the transfer instruction as "waiting", associates and stores the transfer instruction and the state information of the transfer instruction, and modifies/updates and stores the state information of the transfer instruction according to a transfer message fed back by the material handling unit.

The material control unit MCS receives the transfer instruction, sets the state information of the transfer instruction as "waiting", and associates and stores the transfer instruction and the state information of the transfer instruction. That is, when the MCS receives a new transfer instruction, the MCS sets a state of the new transfer instruction as "queue waiting" and stores the new transfer instruction in a queue list. The material control unit modifies and stores information on the state (i.e., state information) of the new transfer instruction according to the transfer message fed back by the material handling unit. The state information of the new transfer instruction is updated according to the events reported by the AMHS. For example, when the AMHS reports that the instruction is completed, the state information may be changed to "Finished". When the AMHS reports "Full stocker, Unable to Store", the state information may be changed to "Full stocker, Unfinished".

In one embodiment, when the material handling unit feeds back failure of transport, the material control unit determines a cause of the failure according to information on the failure. If it is determined that the cause of the failure is related to a receiving node for storing the target wafer, the material control unit regenerates the target transfer path for the target wafer, and the material handling unit is controlled to transport the target wafer according to the target transfer path regenerated by the material control unit.

When the material handling unit AMHS feeds back the failure of the transport, the material control unit MCS determines the cause of the failure according to the information on the failure, and the material control unit MCS determines, according to the feedback information on the failure, whether the failure occurs in the stocker or in the material handling unit AMHS. If it is determined that the failure occurs in the stocker, the MCS can regenerate the target transfer path for the target wafer since the FOUP is still on a carrier vehicle of the material handling unit AMHS, and the material handling unit is controlled to transport the target wafer according to the target transfer path regenerated by the material control unit. The MCS can also send a transfer command for transferring the FOUP from the carrier vehicle to a nearby stocker to enable the FOUP from the carrier vehicle to be moved to the nearby stocker. After the FOUP has been returned to the nearby stocker, the MCS sends a command to enable the FOUP to be moved to the destination storage location of the FOUP. If a new transport fails again, the MCS updates a count number of errors and tries again. If the count number of errors exceeds 50, the MCS issues an alarm and stops the command.

In one embodiment, if it is determined that the cause of the failure is related to the receiving node for storing the target wafer, the material control unit regenerates the target transfer path of the target wafer as follows. A temporary node near the receiving node is determined and the destination storage location of the target wafer is obtained from the transfer information. The material control unit regenerates the target transfer path of the target wafer according to the temporary node, the destination storage location, and the list of routing nodes.

The MCS determines the temporary node near the receiving node and obtains the destination storage location of the target wafer from the transfer information. The material control unit may regenerate the target transfer path for the target wafer by performing operations at 401 to 405 to according to the temporary node, the destination storage location, and the list of routing nodes.

Embodiments further provide a computer device. The computer device includes at least one memory and at least one processor. The at least one memory is configured to store computer programs, and the at least one processor is configured to perform the computer programs to implement: generating, by a manufacturing execution unit, a transfer instruction, where the transfer instruction carries transfer information of a target wafer, the transfer instruction includes a plurality of commands, and the plurality of commands are jointly indicative of a first transfer path based on an instruction sequence of the first transfer path; receiving, by a material control unit, the transfer instruction sent by a production unit according to the instruction sequence of the first transfer path; obtaining, by the material control unit, transfer state information of the target wafer indicated in the transfer instruction; adjusting, by the material control unit, the first transfer path indicated in the transfer information according to the transfer state information, generating a target transfer path of the target wafer, and sending the target transfer path to a material handling unit according to an instruction sequence of the target transfer path; and controlling the material handling unit to transport the target wafer according to the target transfer path sent by the material control unit.

In one embodiment, the processor configured to perform the computer program to adjust the first transfer path indicated in the transfer information according to the transfer state information, and to generate the target transfer path of the target wafer is configured to implement: identifying the first transfer path, an initial storage location, and a destination storage location of the target wafer carried in the transfer information; obtaining a list of routing nodes mapped by all storage locations, where the list of routing nodes includes attribute information of a routing node corresponding to each of the storage locations, and the attribute information includes storage state information and a weight; determining, based on the storage state information of each routing node, transfer routing nodes that are available for temporary storage of the target wafer from the list of routing nodes; determining at least one second transfer path between the initial storage location and the destination storage location according to the transfer routing nodes, where each respective second transfer path of the at least one second transfer path carries a current waiting time and an estimated current transfer time of each transfer routing node in the respective second transfer path; and comparing the at least one second transfer path with the first transfer path to generate the target transfer path of the target wafer.

In one embodiment, the processor configured to perform the computer program to determine, based on the storage state information of each routing node, the transfer routing nodes that are available for the temporary storage of the target wafer from the list of routing nodes is configured to implement: obtaining a list of queuing wafers and a preset storage threshold of each of at least one routing node that is in a positive state and in the list of routing nodes; and determining, according to the preset storage threshold, the target wafer, and queuing wafers in the list of queuing wafers, the transfer routing nodes that are available for the temporary storage of the target wafer, and setting a state of each of at least one routing node that is not available for storage of the target wafer in a preset number of transfer cycles to a negative state.

In one embodiment, the processor configured to perform the computer program is further configured to perform before obtaining a list of queuing wafers and the preset storage threshold of each of at least one routing node that is in a positive state and in the list of routing nodes: receiving a shutdown command sent for at least one specific routing node; and updating, according to the shutdown command, a state of each of the at least one specific routing node in the list of routing nodes to a negative state.

In one embodiment, the processor configured to perform the computer program to receive, by the material control unit, the transfer instruction sent by the production unit, is configured to implement: receiving, by the material control unit, the transfer instruction, setting state information of the transfer instruction as "waiting", and associating and storing the transfer instruction and the state information; and modifying and storing, by the material control unit, the state information of the transfer instruction according to a transfer message fed back by the material handling unit.

In one embodiment, the processor configured to perform the computer program is further configured to: determining, by the material control unit, a cause of a failure according to information on the failure in response to transport failure fed back by the material handling unit, including: regenerating, by the material control unit, the target transfer path of the target wafer in response to determining that the cause of the failure is related to a receiving node for storing the target wafer; and controlling the material handling unit to transport the target wafer according to the target transfer path regenerated by the material control unit.

In one embodiment, the processor configured to perform the computer program to regenerate, by the material control unit, the target transfer path of the target wafer in response to determining that the cause of the failure is related to the receiving node for storing the target wafer is configured to implement: determining a temporary node near the receiving node and obtaining a destination storage location of the target wafer from the transfer information; and regenerating, by the material control unit, the target transfer path of the target wafer according to the temporary node, the destination storage location and the list of routing nodes.

Embodiments further provides a computer-readable storage medium, storing a computer program thereon, where the computer program, when executed by a processor, cause the processor to implement: generating, by a manufacturing execution unit, a transfer instruction, where the transfer instruction carries transfer information of a target wafer, the transfer instruction includes a plurality of commands, and the plurality of commands are jointly indicative of a first transfer path based on an instruction sequence of the first transfer path; receiving, by a material control unit, the transfer instruction sent by a production unit according to the instruction sequence of the first transfer path; obtaining, by the material control unit, transfer state information of the target wafer indicated in the transfer instruction; adjusting, by the material control unit, the first transfer path indicated in the transfer information according to the transfer state information, generating a target transfer path of the target wafer, and sending the target transfer path to a material handling unit according to an instruction sequence of the target transfer path; and controlling the material handling unit to transport the target wafer according to the target transfer path sent by the material control unit.

In one embodiment, the step, implemented by the processor when executing the computer program, of adjusting the first transfer path indicated in the transfer information according to the transfer state information, and generating the target transfer path of the target wafer, includes: identifying the first transfer path, an initial storage location, and a destination storage location of the target wafer carried in the transfer information; obtaining a list of routing nodes mapped by all storage locations, where the list of routing nodes includes attribute information of a routing node corresponding to each of the storage locations, and the attribute information includes storage state information and a weight; determining, based on the storage state information of each routing node, transfer routing nodes that are available for temporary storage of the target wafer from the list of routing nodes; determining at least one second transfer path between the initial storage location and the destination storage location according to the transfer routing nodes, where each respective second transfer path of the at least one second transfer path carries a current waiting time and an estimated current transfer time of each of at least two transfer routing nodes in the respective second transfer path; and comparing the at least one second transfer path with the first transfer path to generate the target transfer path of the target wafer.

In one embodiment, the step, implemented by the processor when executing the computer program, of determining, based on the storage state information of each routing node, the transfer routing nodes that are available for the temporary storage of the target wafer from the list of routing nodes, includes: obtaining a list of queuing wafers and a preset storage threshold of each of at least one routing node that is in a positive state and in the list of routing nodes; and determining, according to the preset storage threshold, the target wafer, and queuing wafers in the list of queuing wafers, the transfer routing nodes that are available for the temporary storage of the target wafer, and setting a state of each of at least one routing node that is not available for storage of the target wafer in a preset number of transfer cycles to a negative state.

In one embodiment, before obtaining a list of queuing wafers and the preset storage threshold of each of at least one routing node that is in a positive state and in the list of routing nodes, the step, implemented by the processor when executing the computer program, of further includes: receiving a shutdown command sent for at least one specific routing node; and updating, according to the shutdown command, a state of each of the at least one specific routing node in the list of routing nodes to a negative state.

In one embodiment, the step, implemented by the processor when executing the computer program, of receiving, by the material control unit, the transfer instruction sent by the production unit, includes: receiving, by the material control unit, the transfer instruction, setting state information of the transfer instruction as "waiting", and associating and storing the transfer instruction and the state information of the transfer instruction; and modifying and storing, by the material control unit, the state information of the transfer instruction according to a transfer message fed back by the material handling unit.

In one embodiment, the processor implements, when executing the computer program, the step of determining, by the material control unit, a cause of a failure according to information on the failure in response to transport failure fed back by the material handling unit, including: regenerating, by the material control unit, the target transfer path of the target wafer in response to determining that the cause of the failure is related to a receiving node for storing the target wafer; and controlling the material handling unit to transport the target wafer according to the target transfer path regenerated by the material control unit.

In one embodiment, the step, implemented by the processor when executing the computer program, of regenerating, by the material control unit, the target transfer path of the target wafer in response to determining that the cause of the failure is related to the receiving node for storing the target wafer, includes: determining a temporary node near the receiving node and obtaining a destination storage location of the target wafer from the transfer information; and regenerating, by the material control unit, the target transfer path of the target wafer according to the temporary node, the destination storage location and the list of routing nodes.

The above are only specific embodiments of the present disclosure, but the scope of protection of the present disclosure is not limited thereto. Changes and substitutions which may be easily conceivable to those skilled in the art within the technical scope disclosed in the present disclosure should fall within the scope of protection of the present disclosure. Therefore, the scope of protection of the present disclosure should be defined by the appended claims.

## Claims

1. A wafer transfer supervision control method, comprising:
generating, by a manufacturing execution unit, a transfer instruction, wherein the transfer instruction carries transfer information of a target wafer, the transfer instruction comprises a plurality of commands, and the plurality of commands are jointly indicative of a first transfer path based on an instruction sequence of the first transfer path;
receiving, by a material control unit, the transfer instruction sent by a production unit according to the instruction sequence of the first transfer path;
obtaining, by the material control unit, transfer state information of the target wafer indicated in the transfer instruction;
adjusting, by the material control unit, the first transfer path indicated in the transfer information according to the transfer state information, generating a target transfer path of the target wafer, and sending the target transfer path to a material handling unit according to an instruction sequence of the target transfer path; and
controlling the material handling unit to transport the target wafer according to the target transfer path sent by the material control unit.

2. The method according to claim 1, wherein the step of adjusting, by the material control unit, the first transfer path indicated in the transfer information according to the transfer state information, and generating the target transfer path of the target wafer, comprises:
identifying the first transfer path, an initial storage location, and a destination storage location of the target wafer carried in the transfer information;
obtaining a list of routing nodes mapped by all storage locations, wherein the list of routing nodes includes attribute information of a routing node corresponding to each of the storage locations, and the attribute information comprises storage state information and a weight;
determining, based on the storage state information of each routing node, transfer routing nodes that are available for temporary storage of the target wafer from the list of routing nodes;
determining at least one second transfer path between the initial storage location and the destination storage location according to the transfer routing nodes, wherein each respective second transfer path of the at least one second transfer path carries a current waiting time and an estimated current transfer time of each of at least two transfer routing nodes in the respective second transfer path; and
comparing the at least one second transfer path with the first transfer path to generate the target transfer path of the target wafer.

3. The method according to claim 2, wherein the step of determining, based on the storage state information of each routing node, the transfer routing nodes that are available for the temporary storage of the target wafer from the list of routing nodes, comprises:
obtaining a list of queuing wafers and a preset storage threshold of each of at least one routing node that is in a positive state and in the list of routing nodes; and
determining, according to the preset storage threshold, the target wafer, and queuing wafers in the list of queuing wafers, the transfer routing nodes that are available for the temporary storage of the target wafer, and setting a state of each of at least one routing node that is not available for storage of the target wafer in a preset number of transfer cycles to a negative state.

4. The method according to claim 3, wherein the method further comprises:
before obtaining the list of queuing wafers and the preset storage threshold of each of the at least one routing node that is in the positive state and in the list of routing nodes,
receiving a shutdown command sent for at least one specific routing node; and
updating, according to the shutdown command, a state of each of the at least one specific routing node in the list of routing nodes to a negative state.

5. The method according to claim 1, wherein the step of receiving, by the material control unit, the transfer instruction sent by the production unit, comprises:
receiving, by the material control unit, the transfer instruction, setting state information of the transfer instruction as "waiting", and associating and storing the transfer instruction and the state information of the transfer instruction; and
modifying and storing, by the material control unit, the state information of the transfer instruction according to a transfer message fed back by the material handling unit.

6. The method according to claim 1, wherein the method further comprises:
determining, by the material control unit, a cause of a failure according to information on the failure in response to transport failure fed back by the material handling unit, including:
regenerating, by the material control unit, the target transfer path of the target wafer in response to determining that the cause of the failure is related to a receiving node for storing the target wafer; and
controlling the material handling unit to transport the target wafer according to the target transfer path regenerated by the material control unit.

7. The method according to claim 6, wherein the step of regenerating, by the material control unit, the target transfer path of the target wafer in response to determining that the cause of the failure is related to the receiving node for storing the target wafer, comprises:
determining a temporary node near the receiving node and obtaining a destination storage location of the target wafer from the transfer information; and
regenerating, by the material control unit, the target transfer path of the target wafer according to the temporary node, the destination storage location, and the list of routing nodes.

8. A wafer transfer supervision control system, comprising:
a manufacturing execution unit configured to generate a transfer instruction, wherein the transfer instruction carries transfer information of a target wafer, the transfer instruction comprises a plurality of commands, and the plurality of commands are jointly indicative of a first transfer path based on an instruction sequence of the first transfer path;
a material control unit configured to receive the transfer instruction sent by a production unit according to the instruction sequence of the first transfer path, to obtain transfer state information of the target wafer indicated in the transfer instruction, to adjust the first transfer path indicated in the transfer information according to the transfer state information, to generate a target transfer path of the target wafer, and to send the target transfer path to a material handling unit according to an instruction sequence of the target transfer path; and
the material handling unit being configured to transport the target wafer according to the target transfer path sent by the material control unit.

9. A computer device, comprising at least one memory and at least one processor, wherein the at least one memory is configured to store computer programs and the at least one processor is configured to execute the computer programs to implement the method according to any of claims 1 to 7.

10. A computer-readable storage medium, storing computer programs, wherein the computer programs, when executed by at least one processor, causes the at least one processor to implement the method according to any of claims 1 to 7.
